# EUROPEAN PATENT APPLICATION

(11) **EP 2 760 051 A2**
(43) Date of publication of application: **30.07.2014**
(21) Application number: 13192432.6
(22) Date of filing: 12.11.2013
(51) Int. Cl.: H01L 29/778, H01L 29/423, H01L 21/338

(54) **High Electron Mobility Transistor (HEMT)**

(30) Priority: 28.01.2013 JP 2013013144
(71) Applicant: FUJITSU LIMITED, Kawasaki-shi, Kanagawa 211-8588 (JP)
(72) Inventor: Kamada, Youichi, Kawasaki-shi, Kanagawa 211-8588 (JP)
(74) Representative: Wilding, Frances Ward

(57) **Abstract**

A semiconductor device includes: a first buffer layer formed on a substrate; a second buffer layer formed on a portion of the first buffer layer; a third buffer layer formed on the first buffer layer and the second buffer layer; a first semiconductor layer formed on the third buffer layer; a second semiconductor layer formed on the first semiconductor layer; and a gate electrode, a source electrode, and a drain electrode that are formed on the second semiconductor layer, wherein the second buffer layer is composed of a material with higher resistivity than the first semiconductor layer; and the second buffer layer is formed in a region immediately below and between the gate electrode and the drain electrode.

## Description

### FIELD

The embodiment discussed herein is related to a semiconductor device.

### BACKGROUND

Nitride semiconductors such as GaN, AlN, InN, and the like or mixed crystal materials thereof have wide band gaps and are used for a high-output electronic device, a short-wavelength light-emitting device, and the like. Among these devices, with respect to the high-output device, techniques for field-effect transistors (FET), particularly high electron mobility transistors (HEMT), are developed (for example, Japanese Laid-open Patent Publication No. 2002-359256). The HEMT using such nitride semiconductors is used for a high-output high-efficiency amplifier, a high-power switching device, and the like.

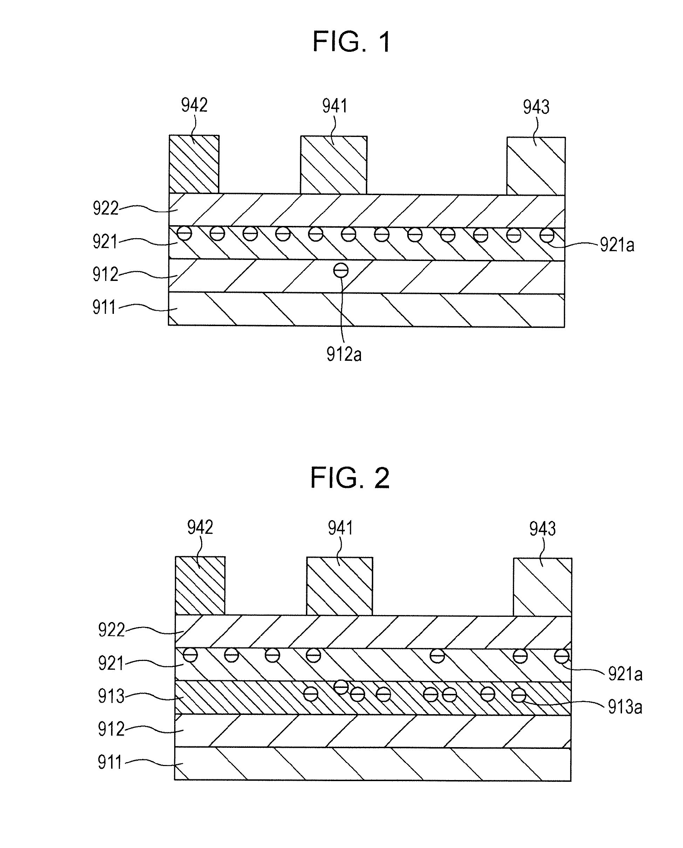

The HEMT using such nitride semiconductors is desired to be stably operated even when operated at high frequency. For example, in HEMT illustrated in FIG. 1, a buffer layer 912, an electron transit layer 921, and an electron supply layer 922 are sequentially laminated on a substrate 911, and a gate electrode 941, a source electrode 942, and a drain electrode 943 are formed on the electron supply layer 922.

The buffer layer 912 includes an AlN layer and an AlGaN layer, the electron transit layer 921 is composed of GaN, and the electron supply layer 922 is composed of AlGaN. In the HEMT having such a structure, two-dimensional electron gas (2DEG) is generated in the electron transit layer 921 near the interface between the electron transit layer 921 and the electron supply layer 922.

However, in the HEMT having the structure illustrated in FIG. 1, during an off state of the HEMT, current easily flows in the buffer layer 912 and the electron transit layer 921, thereby increasing a pinch-off leakage. Therefore, as illustrated in FIG. 2, HEMT with a structure in which a high-resistivity semiconductor layer 913 composed of Fe-doped GaN is provided between the buffer layer 912 and the electron transit layer 921 is investigated. In this HEMT, a pinch-off leakage can be suppressed by providing the high-resistivity semiconductor layer 913.

However, electrons 913a are trapped even in the high-resistivity semiconductor layer 913, and thus 2DEG 921a is decreased, thereby increasing on-resistance and degrading characteristics.

Therefore, as a semiconductor device such as a field-effect transistor or the like which uses a nitride semiconductor such as GaN as a semiconductor material, a semiconductor device having good characteristics with little pinch-off leakage and no increase in on-resistance is demanded.

### SUMMARY

It is desirable to provide a field-effect transistor having good characteristics with little pinch-off leakage and no increase in on-resistance. The invention is defined in the independent claims, to which reference should now be made. Advantageous embodiments are set out in the sub claims.

According to an embodiment of one aspect of the invention, a semiconductor device includes: a first buffer layer formed on a substrate; a second buffer layer formed on a portion of the first buffer layer; a third buffer layer formed on the first buffer layer and the second buffer layer; a first semiconductor layer formed on the third buffer layer; a second semiconductor layer formed on the first semiconductor layer; and a gate electrode, a source electrode, and a drain electrode that are formed on the second semiconductor layer, wherein the second buffer layer is composed of a material with higher resistivity than the first semiconductor layer; and the second buffer layer is formed in a region immediately below and between the gate electrode and the drain electrode. According to another embodiment of another aspect of the invention, a semiconductor device includes: a first buffer layer formed on a substrate; a second buffer layer formed on a portion of the first buffer layer; a third buffer layer formed to cover the second buffer layer; a first semiconductor layer formed on the first buffer layer and the third buffer layer; a second semiconductor layer formed on the first semiconductor layer; and a gate electrode, a source electrode, and a drain electrode that are formed on the second semiconductor layer, wherein the second buffer layer is composed of a material with higher resistivity than the first semiconductor layer; and the second buffer layer is formed in a region immediately below and between the gate electrode and the drain electrode. According to one advantageous embodiment of the invention, the second buffer layer is formed in a region immediately below and between the gate electrode and the drain electrode, yet is prevented from being in direct contact with the gate electrode and/or the drain electrode by an intermediate layer, for example, by at least the third buffer layer, and potentially also by an electron transit layer and/or an electron supply layer.

### BRIEF DESCRIPTION OF DRAWINGS

FIG. 1 is a structural drawing of HEMT including a buffer layer;
FIG. 2 is a structural drawing of HEMT including a high-resistivity layer;
FIG. 3 is a structural drawing of a semiconductor device according to a first embodiment;
FIGs. 4A and 4B are explanatory views of an effect obtained by the semiconductor device according to the first embodiment;
FIGs. 5A, 5B, and 5C are drawings of steps of a method for manufacturing the semiconductor device according to the first embodiment;
FIGs. 6A, 6B, and 6C are drawings of steps of a method for manufacturing the semiconductor device according to the first embodiment;
FIGs. 7A and 7B are drawings of steps a method for manufacturing the semiconductor device according to the first embodiment;
FIG. 8 is a structural drawing of a semiconductor device according to a second embodiment;
FIG. 9 is a structural drawing of another semiconductor device according to the second embodiment;
FIGs. 10A, 10B, and 10C are drawings of steps of a method for manufacturing the semiconductor device according to the second embodiment;
FIGs. 11A, 11B, and 11C are drawings of steps of a method for manufacturing the semiconductor device according to the second embodiment;
FIGs. 12A and 12B are drawings of steps of a method for manufacturing the semiconductor device according to the second embodiment;
FIG. 13 is a structural drawing of a semiconductor device according to a third embodiment;
FIGs. 14A, 14B, and 14C are drawings of steps of a method for manufacturing the semiconductor device according to the third embodiment;
FIGs. 15A, 15B, and 15C are drawings of steps of a method for manufacturing the semiconductor device according to the third embodiment;
FIGs. 16A, 16B, and 16C are drawings of steps of a method for manufacturing the semiconductor device according to the third embodiment;
FIG. 17 is a drawing of a step of a method for manufacturing the semiconductor device according to the third embodiment;
FIG. 18 is a structural drawing of a semiconductor device according to a fourth embodiment;
FIG. 19 is a structural drawing of another semiconductor device according to the fourth embodiment;
FIGs. 20A, 20B, and 20C are drawings of steps of a method for manufacturing the semiconductor device according to the fourth embodiment;
FIGs. 21A, 21B, and 21C are drawings of steps of a method for manufacturing the semiconductor device according to the fourth embodiment;
FIGs. 22A, 22B, and 22C are drawings of steps of a method for manufacturing the semiconductor device according to the fourth embodiment;
FIG. 23 is a drawing of a step of a method for manufacturing the semiconductor device according to the fourth embodiment;
FIG. 24 is a structural drawing of a semiconductor device according to a fifth embodiment;
FIGs. 25A, 25B, and 25C are drawings of steps of a method for manufacturing the semiconductor device according to the fifth embodiment;
FIGs. 26A, 26B, and 26C are drawings of steps of a method for manufacturing the semiconductor device according to the fifth embodiment;
FIGs. 27A, 27B, and 27C are drawings of steps of a method for manufacturing the semiconductor device according to the fifth embodiment;
FIG. 28 is a drawing of a step of a method for manufacturing the semiconductor device according to the fifth embodiment;
FIG. 29 is a structural drawing of a semiconductor device according to a sixth embodiment;
FIGs. 30A, 30B, and 30C are drawings of steps of a method for manufacturing the semiconductor device according to the sixth embodiment;
FIGs. 31A, 31B, and 31C are drawings of steps of a method for manufacturing the semiconductor device according to the sixth embodiment;
FIGs. 32A, 32B, and 32C are drawings of steps of a method for manufacturing the semiconductor device according to the sixth embodiment;
FIG. 33 is a drawing of a step of a method for manufacturing the semiconductor device according to the sixth embodiment;
FIG. 34 is an explanatory view of a discrete-packaged semiconductor device according to a seventh embodiment;
FIG. 35 is a circuit diagram of a power supply unit according to the seventh embodiment; and
FIG. 36 is a structural drawing of a high-output amplifier according to the seventh embodiment.

### DESCRIPTION OF EMBODIMENTS

Hereinafter, embodiments are described. The same member is denoted by the same reference numeral and duplicate description thereof is omitted.

### First Embodiment

### (Semiconductor device)

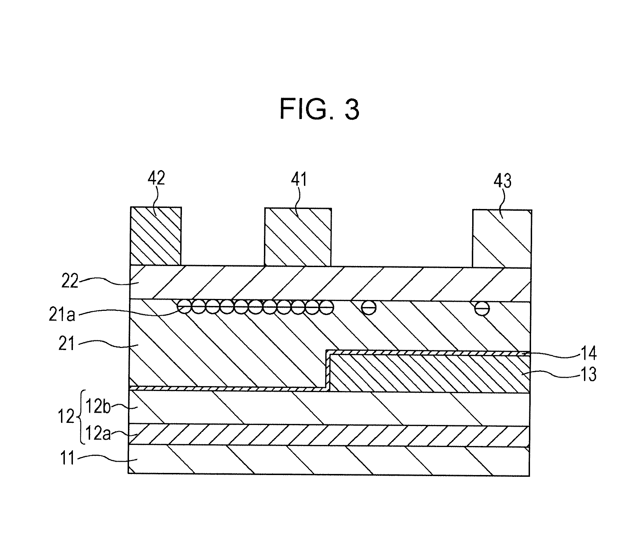

A semiconductor device according to a first embodiment is described on the basis of FIG. 3.

The semiconductor device according to this embodiment includes a substrate 11, an AlN layer 12a formed on the substrate 11 and having a thickness of, for example, about 160 nm, and an AlGaN layer 12b formed on the AlN layer 12a and having a thickness of, for example, about 600 nm. The substrate 11 is composed of a material such as SiC or the like, and the AlN layer 12a and the AlGaN layer 12b are formed by MOVPE (Metal Organic Vapor Phase Epitaxy). The thickness of the AlN layer 12a may be within a range of 1 nm to 300 nm, and the thickness of the AlGaN layer 12b may be within a range of 1 nm to 1000 nm. In this embodiment, a layer including the AlN layer 12a and the AlGaN layer 12b may be referred to as a "first buffer layer 12". The first buffer layer 12 may have a structure other than the above.

A second buffer layer 13 is formed on the first buffer layer 12 in a region immediately below and between a gate electrode 41 and a drain electrode 43. The second buffer layer 13 is not formed in a region immediately below and between the gate electrode 41 and a source electrode 42. A third buffer layer 14 is formed on the first buffer layer 12 in a region immediately below and between the gate electrode 41 and the source electrode 42, on the second buffer layer 13 in a region immediately below and between the gate electrode 41 and the drain electrode 43, and on the side surface of the second buffer layer 13. The third buffer layer 14 is composed of, for example, AlN.

Since the second buffer layer 13 is composed of a material of Fe-doped GaN, the third buffer layer 14 composed of AlN is formed for reducing diffusion of Fe contained in the second buffer layer 13 into an electron transit layer 21 or the like. Therefore, the third buffer layer 14 is formed to cover the second buffer layer 13. Also, since the third buffer layer 14 is composed of AlN, breakdown voltage can be improved due to a decrease in 2DEG 21a.

The electron transit layer 21 composed of i-GaN and serving as a first semiconductor layer and an electron supply layer 22 composed of n-AlGaN or the like and serving as a second semiconductor layer are laminated on the third buffer layer 14. In addition, the gate electrode 41, the source electrode 42, and the drain electrode 43 are formed on the electron supply layer 22.

In the embodiment, 2DEG 21a is generated in the electron transit layer 21 near the interface between the electron transit layer 21 and the electron supply layer 22. However, the second buffer layer 13 is formed immediately below and between the gate electrode 41 and the drain electrode 43, and thus when a turn-off voltage is applied to the gate electrode 41, the 2DEG 21a is decreased between the gate electrode 41 and the drain electrode 43. This can reduce pinch-off leakage.

Since the second buffer layer 13 is not formed between the gate electrode 41 and the source electrode 42, the 2DEG 21a immediately below and between the gate electrode 41 and the source electrode 42 is not reduced. Therefore, an increase in on-resistance can be suppressed, and a decrease in characteristics can be suppressed.

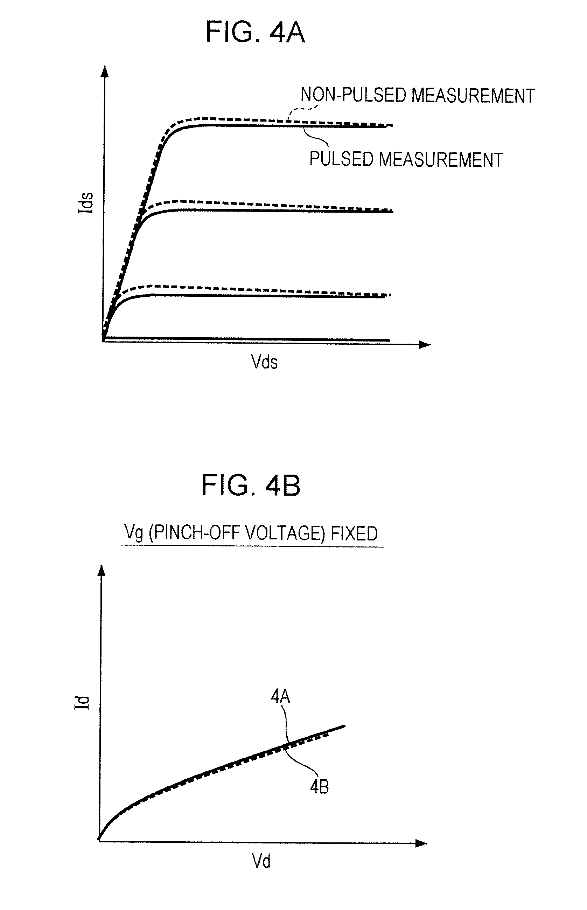

Next, the characteristics of the semiconductor device according to the embodiment are described. FIG. 4A illustrates Vds-Ids characteristics measured by pulsed measurement and non-pulsed measurement of the semiconductor device according to the embodiment. FIG. 4A indicates that the semiconductor device according to the embodiment has small differences in Vds-Ids characteristics between pulsed measurement and non-pulsed measurement. Therefore, in the semiconductor device according to the embodiment, electrons trapped can be decreased, and thus a decrease in characteristics, such as an increase in on-resistance or the like, can be suppressed. FIG. 4B illustrates Vd-Id characteristics 4A of HEMT with a structure illustrated in FIG. 2 and Vd-Id characteristics 4B of the semiconductor device according to the embodiment. FIG. 4B indicates that the Vd-Id characteristics 4A are substantially the same as the Vd-Id characteristics 4B, and like in the HEMT with the structure illustrated in FIG. 2, in the semiconductor device according to the embodiment, pinch-off leakage can be suppressed.

### (Method for manufacturing semiconductor device)

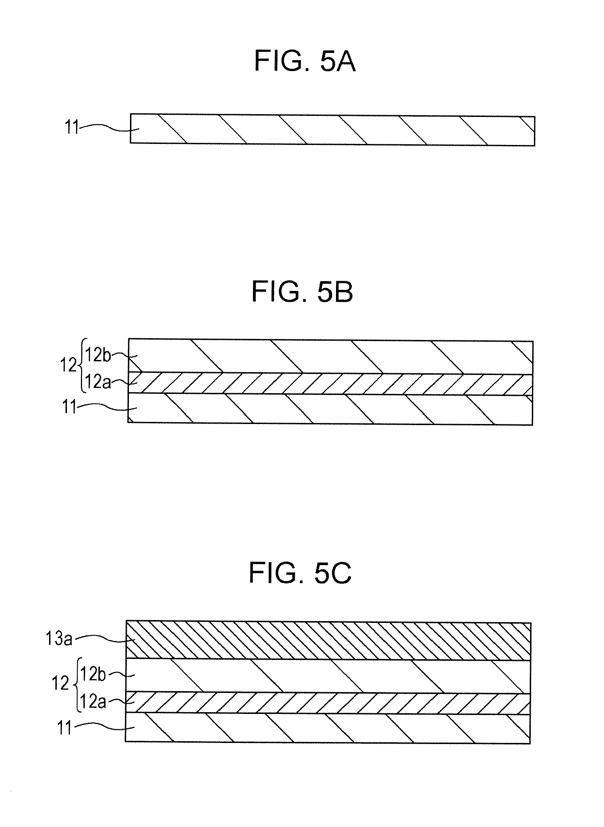

Next, a method for manufacturing the semiconductor device according to the embodiment is described on the basis of FIG. 5A to FIG. 7B.

First, as illustrated in FIG. 5A, the substrate 11 composed of SiC is prepared. The substrate 11 may be composed of Si or the like other than SiC.

Next, as illustrated in FIG. 5B, the AlN layer 12a and the AlGaN layer 12b are sequentially laminated on the substrate 11 by MOVPE. The thus-formed AlN layer 12a and AlGaN layer 12b form the first buffer layer 12. The AlN layer 12a is formed to have a thickness of 1 nm to 300 nm, for example, about 160 nm, and the AlGaN layer 12b is formed to have a thickness of 1 nm to 1000 nm, for example, about 600 nm. When the AlN layer 12a is formed by MOVPE, trimethylaluminum (TMAl) gas and ammonia (NH₃) gas or the like are used. When the AlGaN layer 12b is formed by MOVPE, trimethylaluminum (TMAl) gas, trimethylgallium (TMGa) gas, and ammonia (NH₃) gas or the like are used.

Next, as illustrated in FIG. 5C, a high-resistivity film 13a is formed on the first buffer layer 12 by MOVPE using Fe-doped GaN. The high-resistivity film 13a is composed of GaN doped with Fe at a concentration of about 1 × 10¹⁸ cm⁻³ and is formed to have a thickness of about 100 nm. When the high-resistivity film 13a is formed by MOVPE, trimethylgallium (TMGa) gas, ammonia (NH₃) gas, and iron chloride (FeCl₂) gas or the like are used. In this embodiment, in order to form the high-resistivity film 13a having desired resistivity, the film is preferably formed to have a Fe doping concentration of 1 × 10¹⁷ cm⁻³ or more and have a thickness of 30 nm or more and 800 nm or less. The thus-formed high-resistivity film 13a has higher resistivity than the electron transit layer 21.

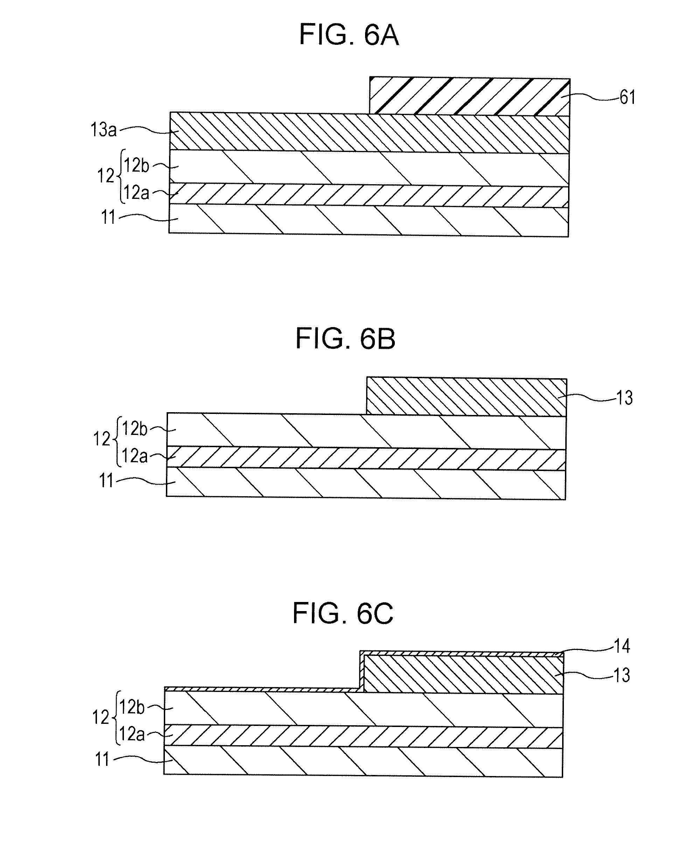

Next, as illustrated in FIG. 6A, a resist pattern 61 is formed on the high-resistivity film 13a in a region where the second buffer layer 13 is to be formed. Specifically, photoresist is applied on the high-resistivity film 13a and then exposed and developed by an exposure apparatus to form the resist pattern 61 in the region where the second buffer layer 13 is to be formed. In the embodiment, the second buffer layer 13 is formed in a region immediately below and between the gate electrode 41 and the drain electrode 43.

Next, as illustrated in FIG. 6B, the high-resistivity film 13a is removed from a region where the resist pattern has not been formed, that is, a region immediately below and between the gate electrode 41 and the source electrode 42, by dry etching such as RIE (Reactive Ion Etching) or the like. As a result, the remaining high-resistivity film 13a forms the second buffer layer 13 composed of Fe-doped GaN. Then, the resist pattern 61 is removed with an organic solvent or the like.

Next, as illustrated in FIG. 6C, the third buffer layer 14 composed of AlN and having a thickness of 1 nm to 500 nm, for example, about 30 nm, is formed on the exposed first buffer layer 12 and second buffer layer 13 by MOVPE. Consequently, the surface of the first buffer layer 12 and the surface and side of the second buffer layer 13 are covered with the third buffer layer 14. When the third buffer layer 14 is formed by MOVPE, trimethylaluminum (TMAl) gas and ammonia (NH₃) gas or the like are used.

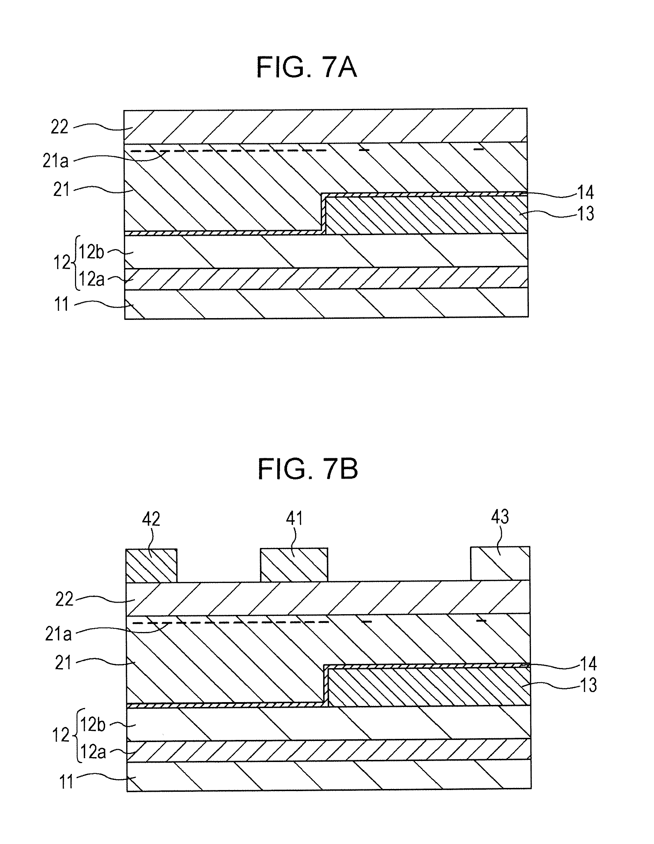

Next, as illustrated in FIG. 7A, the electron transit layer 21 serving as the first semiconductor layer and composed of i-GaN and the electron supply layer 22 serving as the second semiconductor layer and composed of n-AlGaN are sequentially laminated on the third buffer layer 14 by MOVPE. The electron transit layer 21 is formed to have a thickness of about 3 µm, and when formed by MOVPE, trimethylgallium (TMGa) gas and ammonia (NH₃) gas or the like are used. The electron supply layer 22 is formed to have a thickness of about 30 nm and is doped with Si as an n-type impurity element at a concentration of about 5 × 10¹⁸ cm⁻³. Although not illustrated in FIG. 7A, a spacer layer composed of i-AlGaN or the like may be formed between the electron transit layer 21 and the electron supply layer 22. In this case, the space layer is formed to have a thickness of, for example, about 5 nm. In addition, the electron supply layer 22 may be formed to rise by an amount corresponding to the thickness of the second buffer layer 13 in the region where the second buffer layer 13 is formed, but this is not illustrated in FIG. 7A. In this case, the rising portion of the electron supply layer 22 may be removed by polishing or the like to flatten the surface of the electron supply layer 22.

Next, as illustrated in FIG. 7B, the gate electrode 41, the source electrode 42, and the drain electrode 43 are formed on the electron supply layer 22. Specifically, photoresist is applied on the electron supply layer 22 and then exposed and developed by an exposure apparatus to form a resist pattern (not illustrated) having apertures in respective regions where the source electrode 42 and the drain electrode 43 are to be formed respectively. Then, a metal film containing Al is formed by vacuum vapor deposition or the like, and then the metal film formed on the resist pattern is removed by lift-off together with the resist pattern through immersion in an organic solvent or the like. As a result, the remaining metal film forms the source electrode 42 and the drain electrode 43. Then, the source electrode 42 and the drain electrode 43 are put into ohmic contact by heat treatment at a temperature of 400°C to 1000°C, for example, a temperature of about 550°C, in a nitrogen atmosphere. Next, photoresist is again applied on the electron supply layer 22 and then exposed and developed by an exposure apparatus to form a resist pattern (not illustrated) having an aperture in a region where the gate electrode 41 is to be formed. Then, a Ni/Au laminated metal film is formed by vacuum vapor deposition or the like, and then the metal film formed on the resist pattern is removed by lift-off together with the resist pattern through immersion in an organic solvent or the like. As a result, the remaining metal film forms the gate electrode 41.

The semiconductor device according to the embodiment can be manufactured by the manufacturing method described above.

### Second Embodiment

### (Semiconductor device)

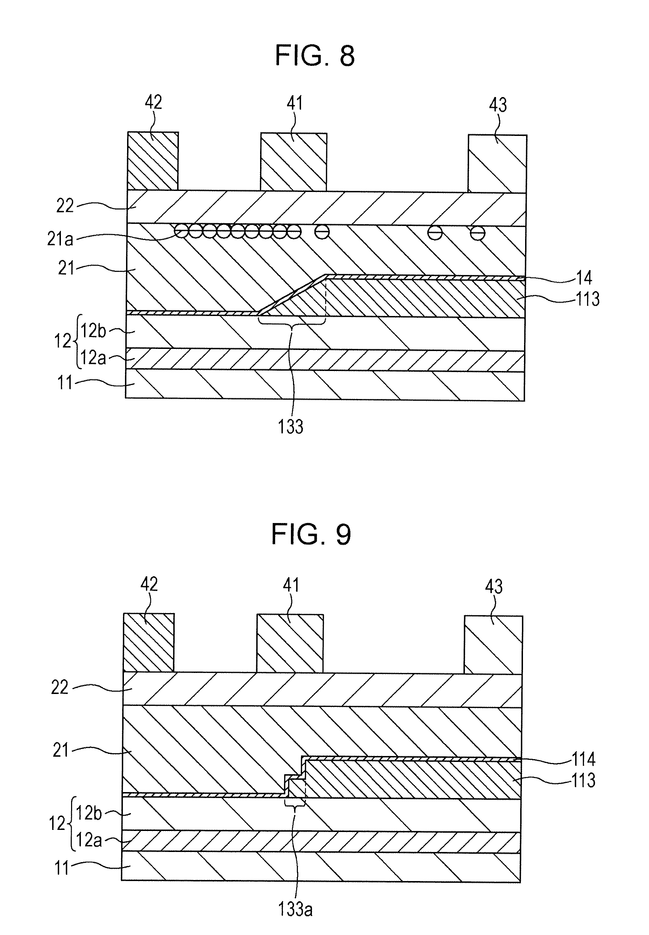

A semiconductor device according to a second embodiment is described on the basis of FIG. 8. This embodiment has a structure in which a second buffer layer is formed to have a tapered or stepped end in a region immediately below a gate electrode 41 or nearly immediately below the gate electrode 41.

The semiconductor device according to this embodiment includes a substrate 11, an AlN layer 12a formed on the substrate 11 and having a thickness of, for example, about 160 nm, and an AlGaN layer 12b formed on the AlN layer 12a and having a thickness of, for example, about 600 nm. The substrate 11 is composed of a material such as SiC or the like, and the AlN layer 12a and the AlGaN layer 12b are formed by MOVPE. In this embodiment, a layer including the AlN layer 12a and the AlGaN layer 12b may be referred to as a "first buffer layer 12".

A second buffer layer 113 is formed on the first buffer layer 12 in a region immediately below and between a gate electrode 41 and a drain electrode 43. The second buffer layer 113 is not formed in a region immediately below and between the gate electrode 41 and a source electrode 42. A third buffer layer 14 composed of AlN is formed on the first buffer layer 12 in a region immediately below and between the gate electrode 41 and the source electrode 42, and on the second buffer layer 113 in a region immediately below and between the gate electrode 41 and the drain electrode 43.

In this embodiment, the second buffer layer 113 is formed to have an end 133 having a tapered inclined surface immediately below the gate electrode 41 or nearly immediately below the gate electrode 41. This can suppress the occurrence of dislocation in the electron transit layer 21 due to an end of the second buffer layer 113. That is, when an end of the second buffer layer rises perpendicularly to the surface of the substrate 11, dislocation easily occurs in the electron transit layer 21. However, in the semiconductor device according to this embodiment, the end 133 of the second buffer layer 113 is formed in a tapered shape, and thus the occurrence of dislocation in the electron transit layer 21 can be suppressed. Therefore, in the embodiment, the occurrence of dislocation in the electron transit layer 21 is suppressed, and thus a decrease in characteristics can be further suppressed.

The electron transit layer 21 composed of i-GaN and serving as a first semiconductor layer and an electron supply layer 22 composed of n-AlGaN or the like and serving as a second semiconductor layer are laminated on the third buffer layer 14. In addition, the gate electrode 41, the source electrode 42, and the drain electrode 43 are formed on the electron supply layer 22.

As illustrated in FIG. 9, in the semiconductor device according to the embodiment, the second buffer layer 113 may be formed to have a stepped end 133a. Like in the case of a tapered shape, even in a case where the second buffer layer 113 is formed to have the stepped end 133a, the occurrence of dislocation in the electron transit layer 21 can be suppressed.

In the semiconductor device according to the embodiment, the occurrence of dislocation in the electron transit layer 21 can be suppressed, and thus a decrease in characteristics can be further suppressed, thereby improving the characteristics.

### (Method for manufacturing semiconductor device)

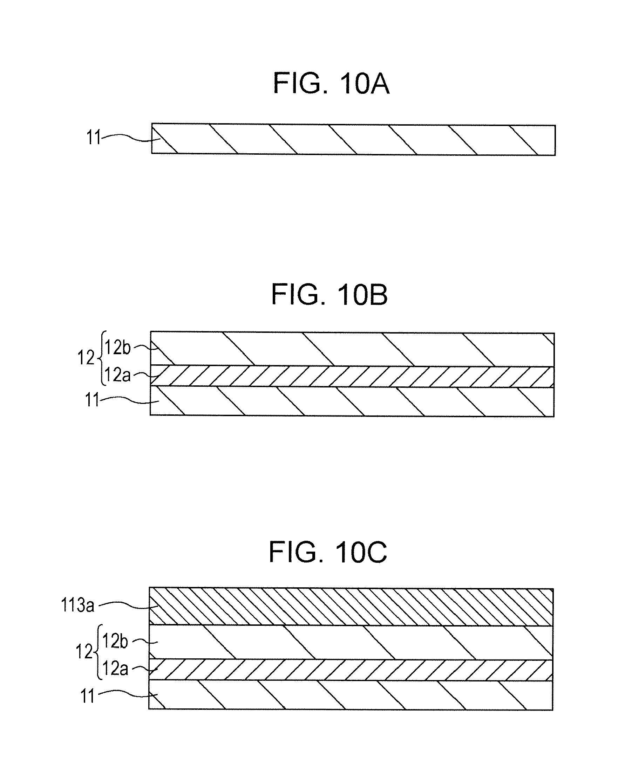

Next, a method for manufacturing the semiconductor device according to the embodiment is described on the basis of FIG. 10A to FIG. 12B.

First, as illustrated in FIG. 10A, the substrate 11 composed of SiC is prepared. The substrate 11 may be composed of Si or the like other than SiC.

Next, as illustrated in FIG. 10B, the AlN layer 12a and the AlGaN layer 12b are sequentially laminated on the substrate 11 by MOVPE. The thus-formed AlN layer 12a and AlGaN layer 12b form the first buffer layer 12. The AlN layer 12a is formed to have a thickness of 1 nm to 300 nm, for example, about 160 nm, and the AlGaN layer 12b is formed to have a thickness of 1 nm to 1000 nm, for example, about 600 nm.

Next, as illustrated in FIG. 10C, a high-resistivity film 113a is formed on the first buffer layer 12 by MOVPE using Fe-doped GaN. The high-resistivity film 113a is composed of GaN doped with Fe at a concentration of about 1 × 10¹⁸ cm⁻³ and is formed to have a thickness of about 100 nm.

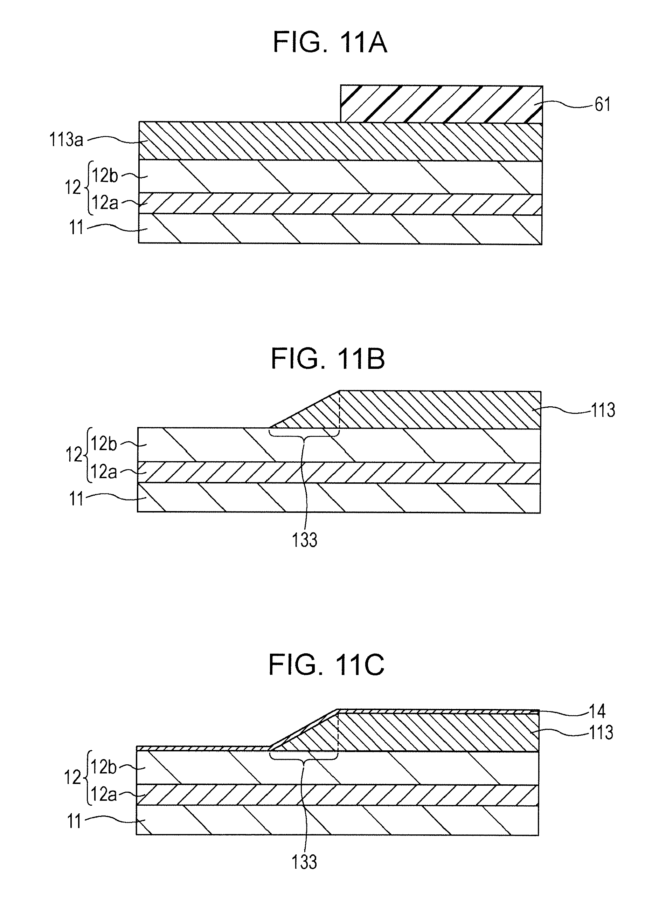

Next, as illustrated in FIG. 11A, a resist pattern 61 is formed on the high-resistivity film 113a in a region where the second buffer layer 113 is to be formed. Specifically, photoresist is applied on the high-resistivity film 113a and then exposed and developed by an exposure apparatus to form the resist pattern 61 in the region where the second buffer layer 113 is to be formed. In the embodiment, the second buffer layer 113 is formed in a region immediately below and between the gate electrode 41 and the drain electrode 43.

Next, as illustrated in FIG. 11B, the high-resistivity film 113a is removed from a region where the resist pattern 61 has not been formed, that is, a region immediately below and between the gate electrode 41 and the source electrode 42, by dry etching such as RIE or the like. In this case, at least one gas selected from BCl₃, CCl₄, Cl₂, CHF₃, C₂H₆, SF₆, and CF₄ is used as etching gas. By dry etching with such etching gas, the second buffer layer 113 can be formed to have the tapered end 133 immediately below the gate electrode 41 or nearly immediately below the gate electrode 41. Similarly, the second buffer layer 113 can be formed to have the tapered end 133 even by adding at least one gas elected from Ar, O₂, H₂, and HBr to the etching gas. As a result, the remaining high-resistivity film 113a forms the second buffer layer 113. Then, the resist pattern 61 is removed with an organic solvent or the like.

Next, as illustrated in FIG. 11C, the third buffer layer 14 composed of AlN and having a thickness of 1 nm to 500 nm, for example, about 30 nm, is formed on the exposed first buffer layer 12 and the second buffer layer 113 by MOVPE. Consequently, the surface of the first buffer layer 12 and the surface and side surface of the second buffer layer 113 are covered with the third buffer layer 14.

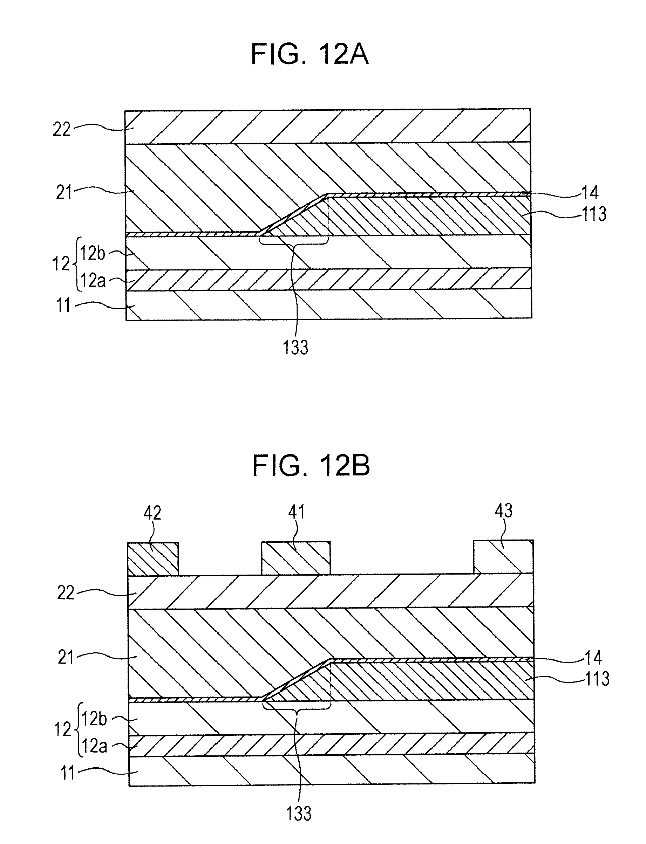

Next, as illustrated in FIG. 12A, the electron transit layer 21 serving as the first semiconductor layer and composed of i-GaN and the electron supply layer 22 serving as the second semiconductor layer and composed of n-AlGaN are sequentially laminated on the third buffer layer 14 by MOVPE.

Next, as illustrated in FIG. 12B, the gate electrode 41, the source electrode 42, and the drain electrode 43 are formed on the electron supply layer 22.

The semiconductor device according to the embodiment can be manufactured by the manufacturing method described above. The contents other than the above are the same as in the first embodiment.

### Third Embodiment

### (Semiconductor Device)

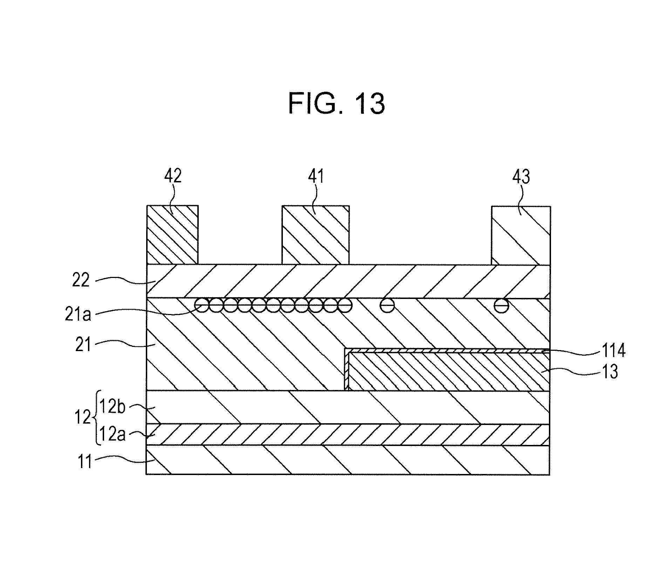

Next, a semiconductor device according to a third embodiment is described on the basis of FIG. 13. This embodiment has a structure in which in the semiconductor device according to the first embodiment, a third buffer layer 114 is formed to cover only the second buffer layer 13 without covering the surface of the first buffer layer 12.

The semiconductor device according to this embodiment includes a substrate 11, an AlN layer 12a formed on the substrate 11 and having a thickness of, for example, about 160 nm, and an AlGaN layer 12b formed on the AlN layer 12a and having a thickness of, for example, about 600 nm. The substrate 11 is composed of a material such as SiC or the like, and the AlN layer 12a and the AlGaN layer 12b are formed by MOVPE. In this embodiment, a layer including the AlN layer 12a and the AlGaN layer 12b may be described as a first buffer layer 12.

The second buffer layer 13 is formed on the first buffer layer 12 in a region immediately below and between a gate electrode 41 and a drain electrode 43. The second buffer layer 13 is not formed in a region immediately below and between the gate electrode 41 and a source electrode 42. The third buffer layer 114 composed of AlN is formed on the second buffer layer 13 in a region immediately below and between the gate electrode 41 and the drain electrode 43. The third buffer layer 114 is formed to cover the second buffer layer 13, but the third buffer layer 114 is not formed on the first buffer layer 12 in a region immediately below and between the gate electrode 41 and the source electrode 42.

The electron transit layer 21 composed of i-GaN and serving as a first semiconductor layer and an electron supply layer 22 composed of n-AlGaN or the like and serving as a second semiconductor layer are laminated on the first buffer layer 12 and the third buffer layer 114. In addition, the gate electrode 41, the source electrode 42, and the drain electrode 43 are formed on the electron supply layer 22.

In the semiconductor device according to this embodiment, the same effect as in the first embodiment can be achieved.

### (Method for manufacturing semiconductor device)

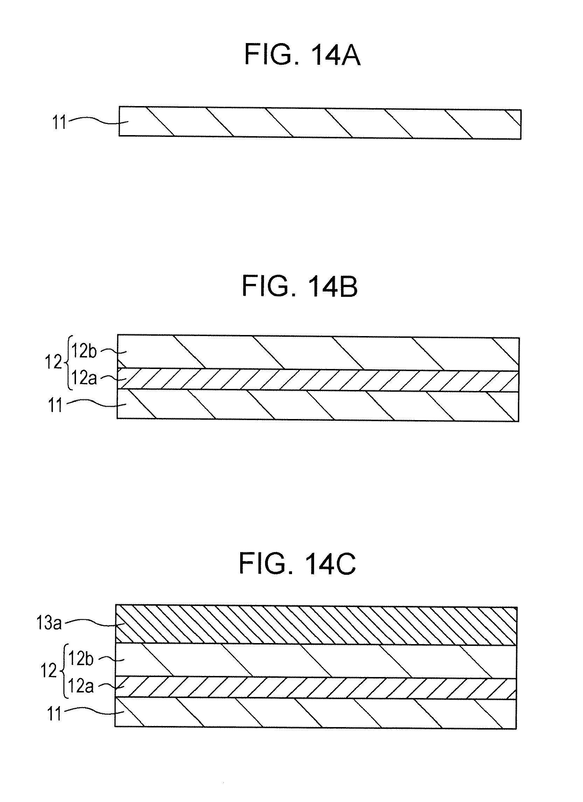

Next, a method for manufacturing the semiconductor device according to the embodiment is described on the basis of FIG. 14A to FIG. 17.

First, as illustrated in FIG. 14A, the substrate 11 composed of SiC is prepared. The substrate 11 may be composed of Si or the like other than SiC.

Next, as illustrated in FIG. 14B, the AlN layer 12a and the AlGaN layer 12b are sequentially laminated on the substrate 11 by MOVPE. The thus-formed AlN layer 12a and AlGaN layer 12b form the first buffer layer 12. The AlN layer 12a is formed to have a thickness of 1 nm to 300 nm, for example, about 160 nm, and the AlGaN layer 12b is formed to have a thickness of 1 nm to 1000 nm, for example, about 600 nm.

Next, as illustrated in FIG. 14C, a high-resistivity film 13a is formed on the first buffer layer 12 by MOVPE using Fe-doped GaN. The high-resistivity film 13a is composed of GaN doped with Fe at a concentration of about 1 × 10¹⁸ cm⁻³ and is formed to have a thickness of about 100 nm.

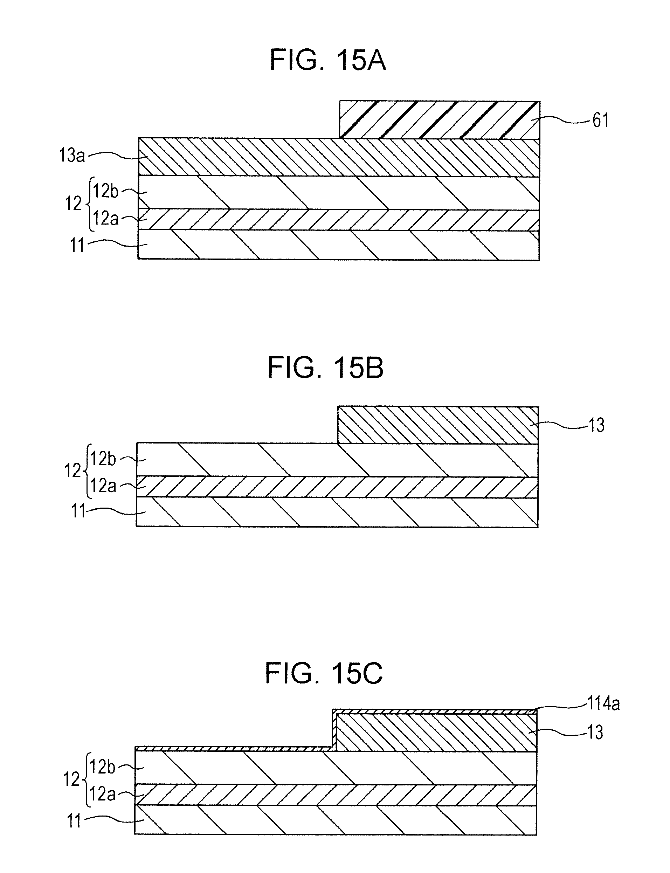

Next, as illustrated in FIG. 15A, a resist pattern 61 is formed on the high-resistivity film 13a in a region where the second buffer layer 13 is to be formed. Specifically, photoresist is applied on the high-resistivity film 13a and then exposed and developed by an exposure apparatus to form the resist pattern 61 in the region where the second buffer layer 13 is to be formed. In the embodiment, the second buffer layer 13 is formed in a region immediately below and between the gate electrode 41 and the drain electrode 43.

Next, as illustrated in FIG. 15B, the high-resistivity film 13a is removed from a region where the resist pattern 61 has not been formed, that is, a region immediately below and between the gate electrode 41 and the source electrode 42, by dry etching such as RIE or the like. As a result, the remaining high-resistivity film 13a forms the second buffer layer 13. Then, the resist pattern 61 is removed with an organic solvent or the like.

Next, as illustrated in FIG. 15C, an AlN film 114a having a thickness of 1 nm to 500 nm, for example, about 30 nm, is formed on the exposed first buffer layer 12 and second buffer layer 13 by MOVPE. Consequently, the surface of the first buffer layer 12 and the surface and side of the second buffer layer 13 are covered with the AlN film 114a.

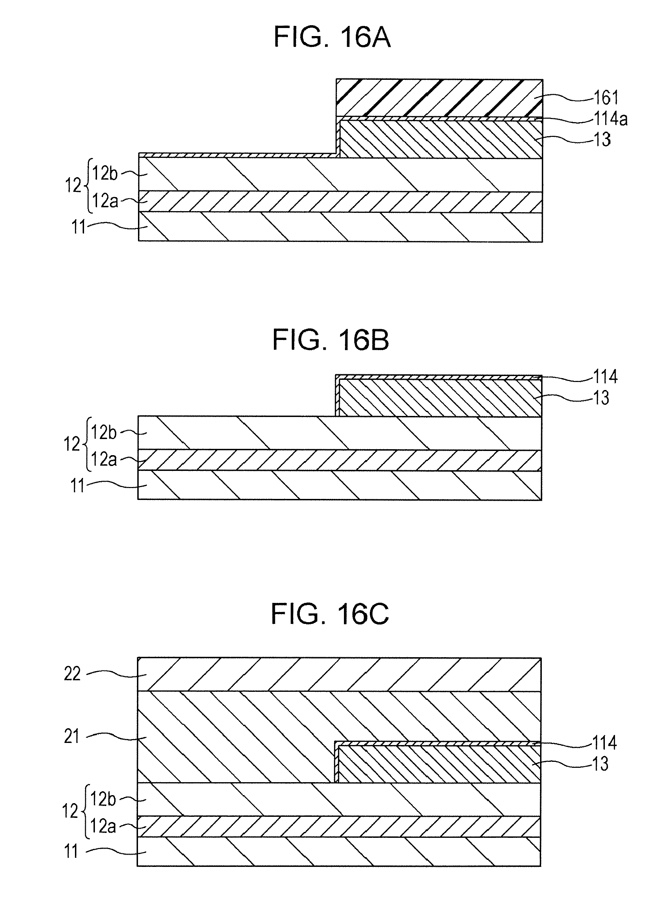

Next, as illustrated in FIG. 16A, a resist pattern 161 is formed on the AlN film 114a in a region where the second buffer layer 13 has been formed. Specifically, photoresist is applied on the AlN film 114a and then exposed and developed by an exposure apparatus to form the resist pattern 161 in the region of the AlN film 114a where the second buffer layer 13 has been formed.

Next, as illustrated in FIG. 16B, the AlN film 114a is removed from a region where the resist pattern 161 has not been formed, that is, a region immediately below and between the gate electrode 41 and the source electrode 42, by dry etching such as RIE or the like. As a result, the remaining AlN film 114a forms the third buffer layer 114 which covers the surface and the side surface of the second buffer layer 13. Then, the resist pattern 161 is removed with an organic solvent or the like.

Next, as illustrated in FIG. 16C, the electron transit layer 21 composed of i-GaN and the electron supply layer 22 composed of n-AlGaN are sequentially laminated on the exposed first buffer layer 12 and third buffer layer 114 by MOVPE.

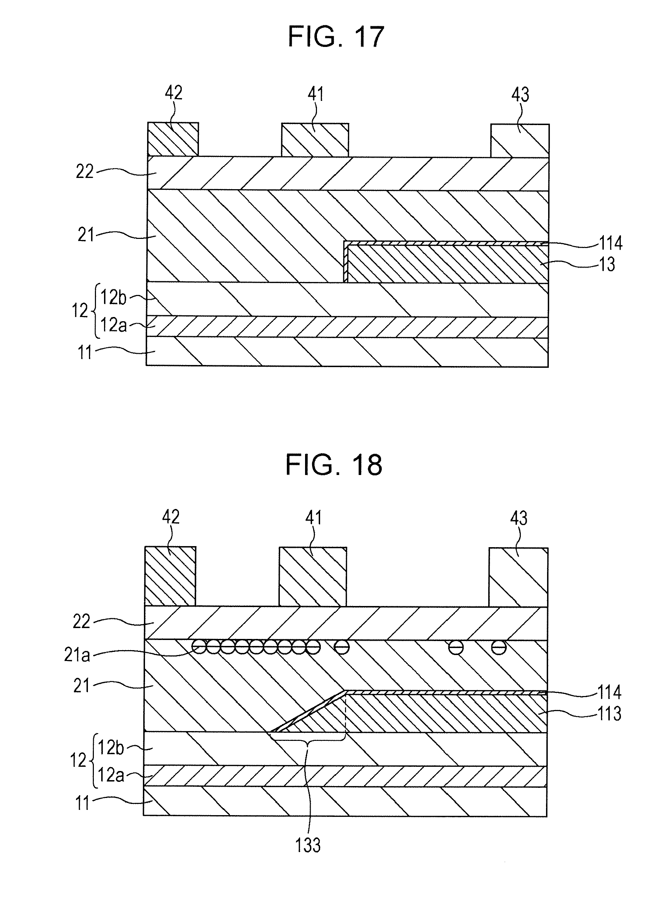

Next, as illustrated in FIG. 17, the gate electrode 41, the source electrode 42, and the drain electrode 43 are formed on the electron supply layer 22.

The semiconductor device according to the embodiment can be manufactured by the manufacturing method described above. The contents other than the above are the same as in the first embodiment.

### Fourth Embodiment

### (Semiconductor Device)

Next, a semiconductor device according to a fourth embodiment is described on the basis of FIG. 18. This embodiment has a structure in which in the third embodiment, a second buffer layer is formed to have a tapered or stepped end immediately below the gate electrode or nearly immediately below the gate electrode 41.

The semiconductor device according to this embodiment includes a substrate 11, an AlN layer 12a formed on the substrate 11 and having a thickness of, for example, about 160 nm, and an AlGaN layer 12b formed on the AlN layer 12a and having a thickness of, for example, about 600 nm. The substrate 11 is composed of a material such as SiC or the like, and the AlN layer 12a and the AlGaN layer 12b are formed by MOVPE. In this embodiment, a layer including the AlN layer 12a and the AlGaN layer 12b may be referred to as a "first buffer layer 12".

A second buffer layer 113 is formed on the first buffer layer 12 in a region immediately below and between the gate electrode 41 and the drain electrode 43. The second buffer layer 113 is not formed in a region immediately below and between the gate electrode 41 and a source electrode 42. The third buffer layer 114 composed of AlN is formed on the second buffer layer 113 in a region immediately below and between the gate electrode 41 and the drain electrode 43. The third buffer layer 114 is formed to cover the second buffer layer 113, but the third buffer layer 114 is not formed on the first buffer layer 12 in a region immediately below and between the gate electrode 41 and the source electrode 42.

In this embodiment, the second buffer layer 113 is formed to have an end 133 with a tapered inclined surface immediately below the gate electrode 41 or nearly immediately below the gate electrode 41. This can suppress the occurrence of dislocation in the electron transit layer 21 due to the formation of the second buffer layer 113.

The electron transit layer 21 composed of i-GaN and serving as a first semiconductor layer and an electron supply layer 22 composed of n-AlGaN or the like and serving as a second semiconductor layer are laminated on the first buffer layer 12 and the third buffer layer 114. In addition, the gate electrode 41, the source electrode 42, and the drain electrode 43 are formed on the electron supply layer 22.

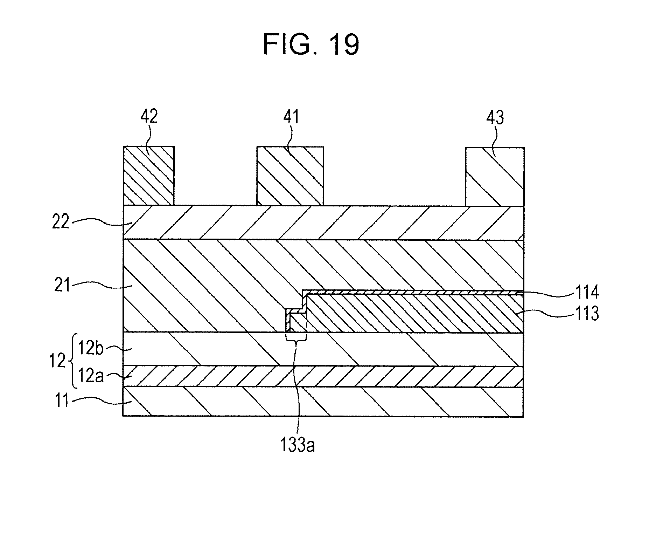

In the semiconductor device according to this embodiment, as illustrated in FIG. 19, the second buffer 113 may be formed to have a stepped end 133a. Like in the case of a tapered shape, even in a case where the second buffer layer 113 is formed to have the stepped end 133a, the occurrence of dislocation in the electron transit layer 21 due to the formation of the second buffer layer 113 can be suppressed.

In the semiconductor device according to this embodiment, the same effect as in the first embodiment can be achieved. Also, in the semiconductor device according to this embodiment, the occurrence of dislocation in the electron transit layer 21 can be suppressed, and thus the characteristics can be further improved.

### (Method for manufacturing semiconductor device)

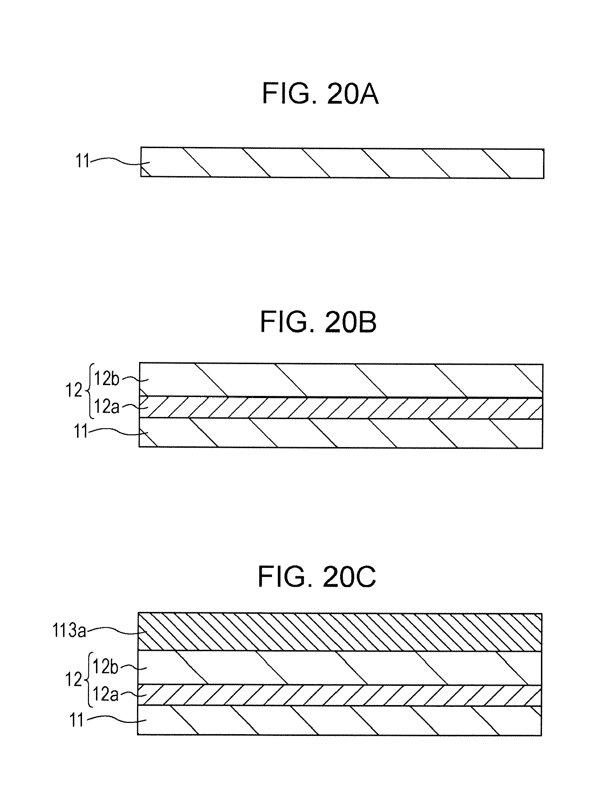

Next, a method for manufacturing the semiconductor device according to the embodiment is described on the basis of FIG. 20A to FIG. 23.

First, as illustrated in FIG. 20A, the substrate 11 composed of SiC is prepared. The substrate 11 may be composed of Si or the like other than SiC.

Next, as illustrated in FIG. 20B, the AlN layer 12a and the AlGaN layer 12b are sequentially laminated on the substrate 11 by MOVPE. The thus-formed AlN layer 12a and AlGaN layer 12b form the first buffer layer 12. The AlN layer 12a is formed to have a thickness of 1 nm to 300 nm, for example, about 160 nm, and the AlGaN layer 12b is formed to have a thickness of 1 nm to 1000 nm, for example, about 600 nm.

Next, as illustrated in FIG. 20C, a high-resistivity film 113a is formed on the first buffer layer 12 by MOVPE using Fe-doped GaN. The high-resistivity film 113a is composed of GaN doped with Fe at a concentration of about 1 × 10¹⁸ cm⁻³ and is formed to have a thickness of about 100 nm.

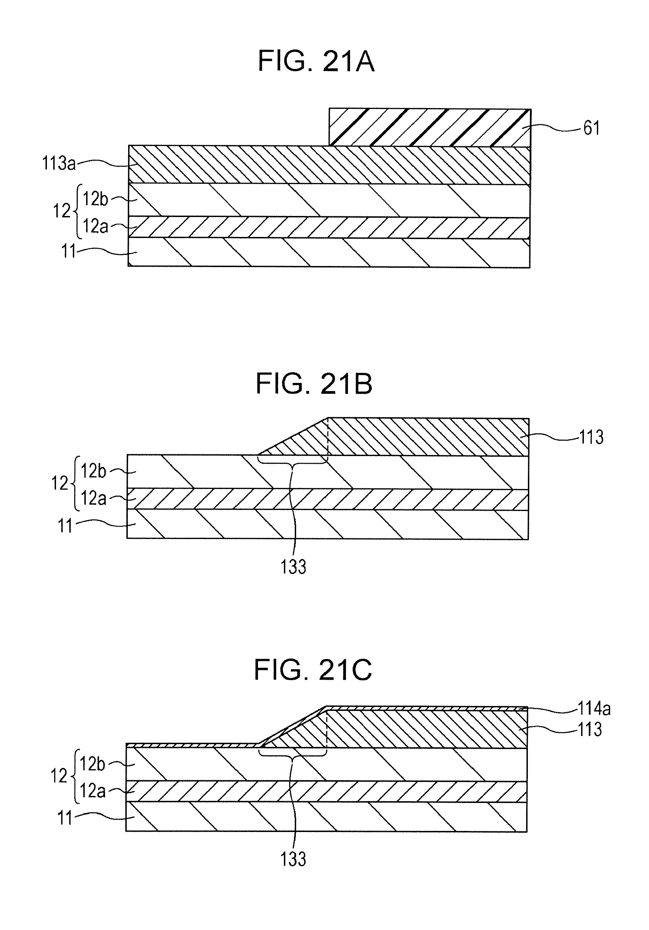

Next, as illustrated in FIG. 21A, a resist pattern 61 is formed on the high-resistivity film 113a in a region where the second buffer layer 113 is to be formed. Specifically, photoresist is applied on the high-resistivity film 113a and then exposed and developed by an exposure apparatus to form the resist pattern 61 in the region where the second buffer layer 113 is to be formed. In the embodiment, the second buffer layer 113 is formed in a region immediately below and between the gate electrode 41 and the drain electrode 43.

Next, as illustrated in FIG. 21B, the high-resistivity film 113a is removed from a region where the resist pattern 61 has not been formed, that is, a region immediately below and between the gate electrode 41 and the source electrode 42, by dry etching such as RIE or the like. In this case, at least one gas selected from BCl₃, CCl₄, Cl₂, CHF₃, C₂H₆, SF₆, and CF₄ is used as etching gas. By dry etching with such etching gas, the second buffer layer 113 can be formed to have the tapered end 133 immediately below the gate electrode 41 or nearly immediately below the gate electrode 41. Similarly, the second buffer layer 113 can be formed to have the tapered end 133 even by adding at least one gas elected from Ar, O₂, H₂, and HBr to the etching gas. As a result, the remaining high-resistivity film 113a forms the second buffer layer 113. Then, the resist pattern 61 is removed with an organic solvent or the like.

Next, as illustrated in FIG. 21C, an AlN film 114a having a thickness of 1 nm to 500 nm, for example, about 30 nm, is formed on the exposed first buffer layer 12 and second buffer layer 113 by MOVPE. Consequently, the surface of the first buffer layer 12 and the surface of the second buffer layer 113 are covered with the AlN film 114a.

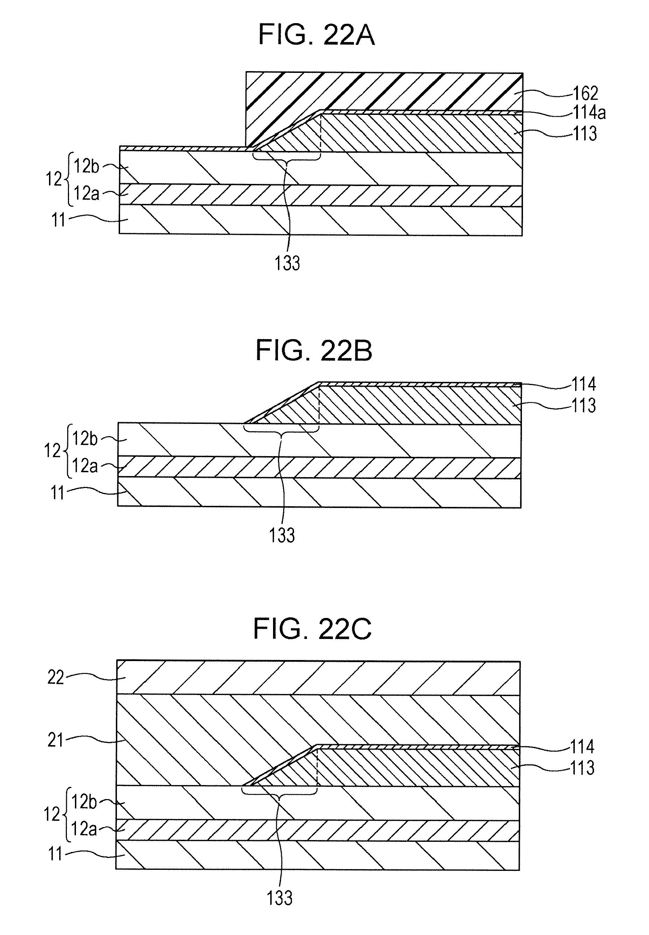

Next, as illustrated in FIG. 22A, a resist pattern 162 is formed on the AlN film 114a in a region where the second buffer layer 113 has been formed. Specifically, photoresist is applied on the AlN film 114a and then exposed and developed by an exposure apparatus to form the resist pattern 162 in the region of the AlN film 114a where the second buffer layer 113 has been formed.

Next, as illustrated in FIG. 22B, the AlN film 114a is removed from a region where the resist pattern 162 has not been formed, that is, a region immediately below and between the gate electrode 41 and the source electrode 42, by dry etching such as RIE or the like. As a result, the remaining AlN film 114a forms the third buffer layer 114 to cover the second buffer layer 113. Then, the resist pattern 162 is removed with an organic solvent or the like.

Next, as illustrated in FIG. 22C, the electron transit layer 21 composed of i-GaN and the electron supply layer 22 composed of n-AlGaN are sequentially laminated on the exposed first buffer layer 12 and third buffer layer 114 by MOVPE.

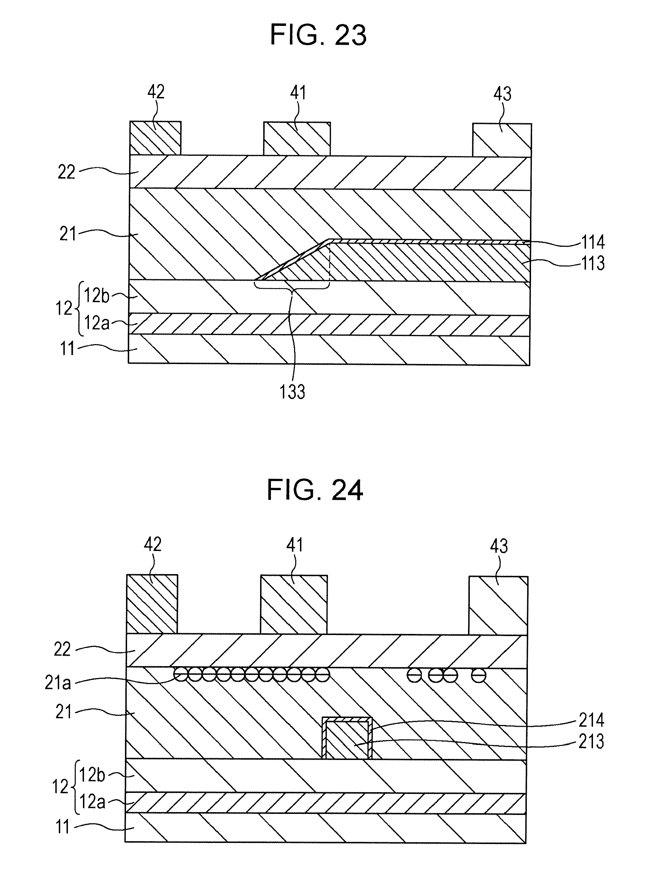

Next, as illustrated in FIG. 23, the gate electrode 41, the source electrode 42, and the drain electrode 43 are formed on the electron supply layer 22.

The semiconductor device according to the embodiment can be manufactured by the manufacturing method described above. The contents other than the above are the same as in the second or third embodiment.

### Fifth Embodiment

### (Semiconductor Device)

Next, a semiconductor device according to a fifth embodiment is described on the basis of FIG. 24. This embodiment has a structure in which a second buffer layer 213 is formed in a portion of a region immediately below and between a gate electrode 41 and a drain electrode 43, and a third buffer layer 214 is formed to cover only the second buffer layer 213.

The semiconductor device according to this embodiment includes a substrate 11, an AlN layer 12a formed on the substrate 11 and having a thickness of, for example, about 160 nm, and an AlGaN layer 12b formed on the AlN layer 12a and having a thickness of, for example, about 600 nm. The substrate 11 is composed of a material such as SiC or the like, and the AlN layer 12a and the AlGaN layer 12b are formed by MOVPE. In this embodiment, a layer including the AlN layer 12a and the AlGaN layer 12b may be referred to as a "first buffer layer 12".

The second buffer layer 213 is formed on the first buffer layer 12 to be disposed in a portion of a region immediately below and between the gate electrode 41 and the drain electrode 43. The second buffer layer 213 is not formed in a region immediately below and between the gate electrode 41 and a source electrode 42. The third buffer layer 214 composed of AlN is formed on the second buffer layer 213 to cover the second buffer layer 213, but the third buffer layer 214 is not formed on the first buffer layer 12 in a region immediately below and between the gate electrode 41 and the source electrode 42.

The electron transit layer 21 composed of i-GaN and serving as a first semiconductor layer and an electron supply layer 22 composed of n-AlGaN or the like and serving as a second semiconductor layer are laminated on the first buffer layer 12 and the third buffer layer 214. In addition, the gate electrode 41, the source electrode 42, and the drain electrode 43 are formed on the electron supply layer 22.

In the semiconductor device according to this embodiment, the same effect as in the first embodiment can be achieved.

### (Method for manufacturing semiconductor device)

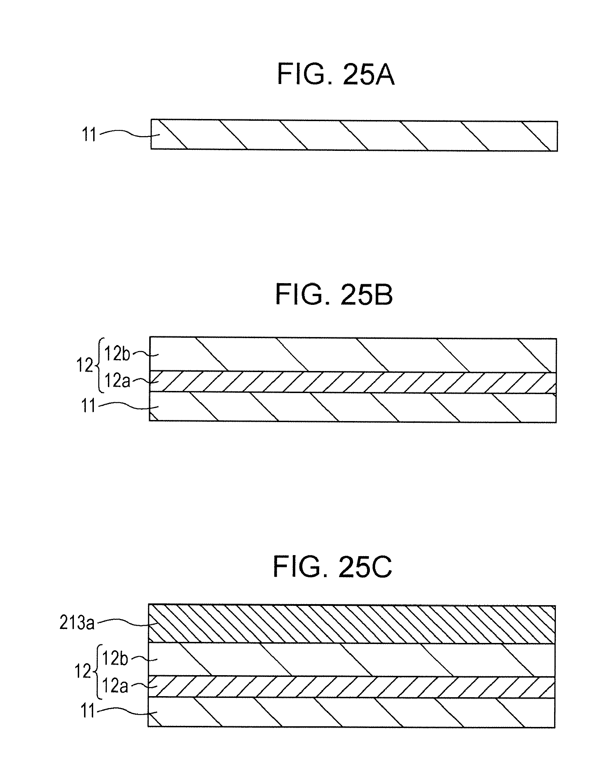

Next, a method for manufacturing the semiconductor device according to the embodiment is described on the basis of FIG. 25A to FIG. 28.

First, as illustrated in FIG. 25A, the substrate 11 composed of SiC is prepared. The substrate 11 may be composed of Si or the like other than SiC.

Next, as illustrated in FIG. 25B, the AlN layer 12a and the AlGaN layer 12b are sequentially laminated on the substrate 11 by MOVPE. The thus-formed AlN layer 12a and AlGaN layer 12b form the first buffer layer 12. The AlN layer 12a is formed to have a thickness of 1 nm to 300 nm, for example, about 160 nm, and the AlGaN layer 12b is formed to have a thickness of 1 nm to 1000 nm, for example, about 600 nm.

Next, as illustrated in FIG. 25C, a high-resistivity film 213a is formed on the first buffer layer 12 by MOVPE using Fe-doped GaN. The high-resistivity film 213a is composed of GaN doped with Fe at a concentration of about 1 × 10¹⁸ cm⁻³ and is formed to have a thickness of about 100 nm.

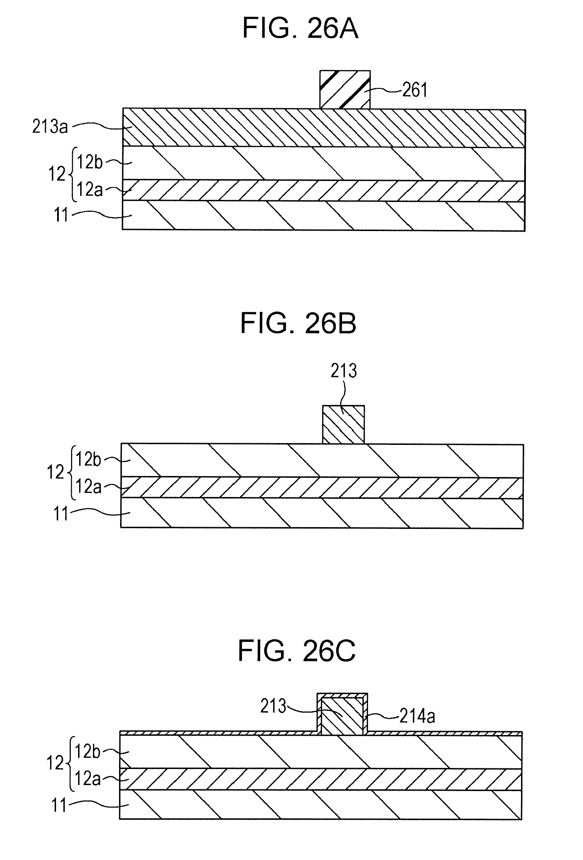

Next, as illustrated in FIG. 26A, a resist pattern 261 is formed on the high-resistivity film 213a in a region where the second buffer layer 213 is to be formed. Specifically, photoresist is applied on the high-resistivity film 213a and then exposed and developed by an exposure apparatus to form the resist pattern 261 in the region where the second buffer layer 213 is to be formed. In the embodiment, the second buffer layer 213 is formed in a portion of a region immediately below and between the gate electrode 41 and the drain electrode 43.

Next, as illustrated in FIG. 26B, the high-resistivity film 213a is removed from a region, where the resist pattern 261 has not been formed, by dry etching such as RIE or the like. As a result, the remaining high-resistivity film 213a forms the second buffer layer 213. Then, the resist pattern 261 is removed with an organic solvent or the like.

Next, as illustrated in FIG. 26C, an AlN film 214a having a thickness of 1 nm to 500 nm, for example, about 30 nm, is formed on the exposed first buffer layer 12 and the second buffer layer 213 by MOVPE. Consequently, the surface of the first buffer layer 12 and the surface and side of the second buffer layer 213 are covered with the AlN film 214a.

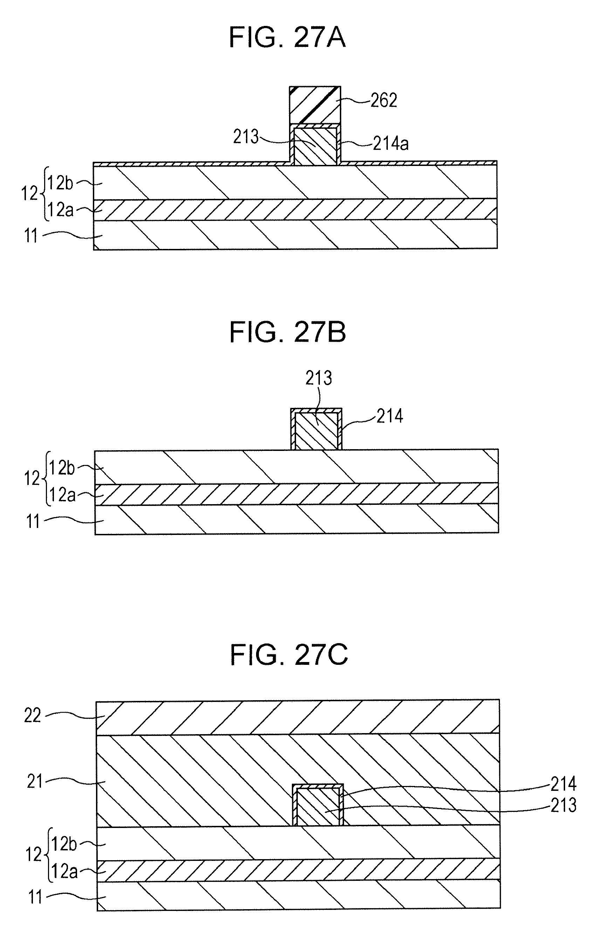

Next, as illustrated in FIG. 27A, a resist pattern 262 is formed on the AlN film 214a in a region where the second buffer layer 213 has been formed. Specifically, photoresist is applied on the AlN film 214a and then exposed and developed by an exposure apparatus to form the resist pattern 262 on the AlN film 214a in the region where the second buffer layer 213 has been formed.

Next, as illustrated in FIG. 27B, the AlN film 214a is removed from a region where the resist pattern 262 has not been formed, by dry etching such as RIE or the like. As a result, the remaining AlN film 214a forms the third buffer layer 214 which covers the surface and the side of the second buffer layer 213. Then, the resist pattern 262 is removed with an organic solvent or the like.

Next, as illustrated in FIG. 27C, the electron transit layer 21 composed of i-GaN and the electron supply layer 22 composed of n-AlGaN are sequentially laminated on the exposed first buffer layer 12 and the third buffer layer 214 by MOVPE.

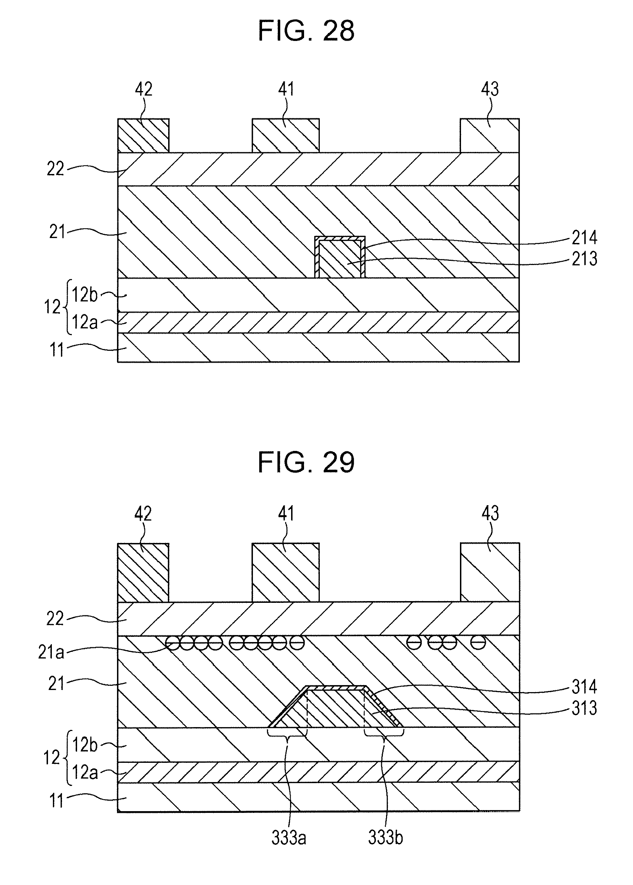

Next, as illustrated in FIG. 28, the gate electrode 41, the source electrode 42, and the drain electrode 43 are formed on the electron supply layer 22.

The semiconductor device according to the embodiment can be manufactured by the manufacturing method described above. The contents other than the above are the same as in the third embodiment.

### Sixth Embodiment

### (Semiconductor device)

A semiconductor device according to a sixth embodiment is described on the basis of FIG. 29. This embodiment has a structure in which a second buffer layer is formed in a portion of a region immediately below and between a gate electrode 41 and a drain electrode 43, and the second buffer layer has a tapered or stepped end.

The semiconductor device according to this embodiment includes a substrate 11, an AlN layer 12a formed on the substrate 11 and having a thickness of, for example, about 160 nm, and an AlGaN layer 12b formed on the AlN layer 12a and having a thickness of, for example, about 600 nm. The substrate 11 is composed of a material such as SiC or the like, and the AlN layer 12a and the AlGaN layer 12b are formed by MOVPE. In this embodiment, a layer including the AlN layer 12a and the AlGaN layer 12b may be described as a first buffer layer 12.

A second buffer layer 313 is formed on the first buffer layer 12 to be disposed in a portion of a region immediately below and between the gate electrode 41 and the drain electrode 43. The second buffer layer 313 is not formed in a region immediately below and between the gate electrode 41 and a source electrode 42. A third buffer layer 314 composed of AlN is formed on the second buffer layer 313 in a region immediately below and between the gate electrode 41 and the drain electrode 43. The third buffer layer 314 is formed to cover the second buffer 331, but not formed on the first buffer layer 12 in a region immediately below and between the gate electrode 41 and the source electrode 42.

In this embodiment, the second buffer layer 313 is formed to have ends 333a and 333b having a tapered inclined surface. This can suppress the occurrence of dislocation in the electron transit layer 21.

The electron transit layer 21 composed of i-GaN and serving as a first semiconductor layer and an electron supply layer 22 composed of n-AlGaN or the like and serving as a second semiconductor layer are laminated on the first buffer layer 12 and the third buffer layer 314. In addition, the gate electrode 41, the source electrode 42, and the drain electrode 43 are formed on the electron supply layer 22.

In the semiconductor device according to the embodiment, the second buffer layer 313 may be formed to have stepped ends 333a and 333b.

In the semiconductor device according to the embodiment, the occurrence of dislocation in the electron transit layer 21 can be suppressed, and thus transistor characteristics can be improved.

### (Method for manufacturing semiconductor device)

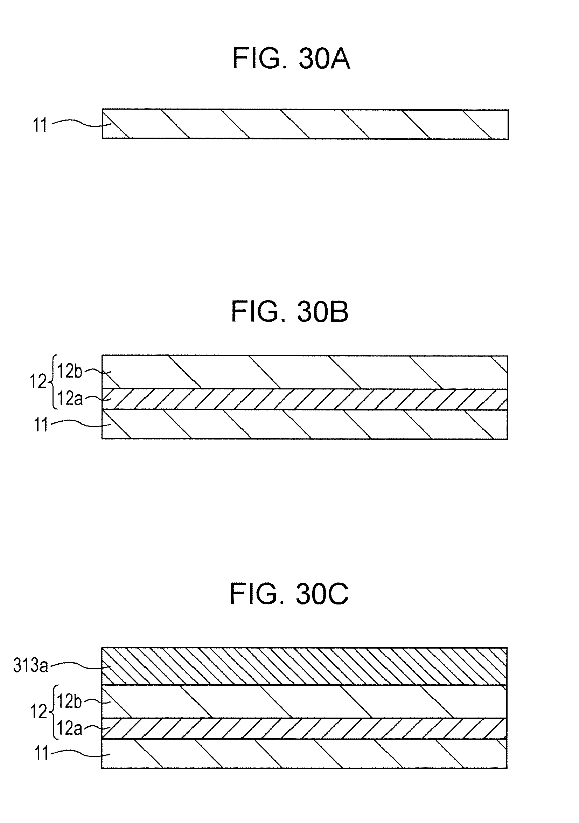

Next, a method for manufacturing the semiconductor device according to the embodiment is described on the basis of FIG. 30A to FIG. 33.

First, as illustrated in FIG. 30A, the substrate 11 composed of SiC is prepared. The substrate 11 may be composed of Si or the like other than SiC.

Next, as illustrated in FIG. 30B, the AlN layer 12a and the AlGaN layer 12b are sequentially laminated on the substrate 11 by MOVPE. The thus-formed AlN layer 12a and AlGaN layer 12b form the first buffer layer 12. The AlN layer 12a is formed to have a thickness of 1 nm to 300 nm, for example, about 160 nm, and the AlGaN layer 12b is formed to have a thickness of 1 nm to 1000 nm, for example, about 600 nm.

Next, as illustrated in FIG. 30C, a high-resistivity film 313a is formed on the first buffer layer 12 by MOVPE using Fe-doped GaN. The high-resistivity film 313a is composed of GaN doped with Fe at a concentration of about 1 × 10¹⁸ cm⁻³ and is formed to have a thickness of about 100 nm.

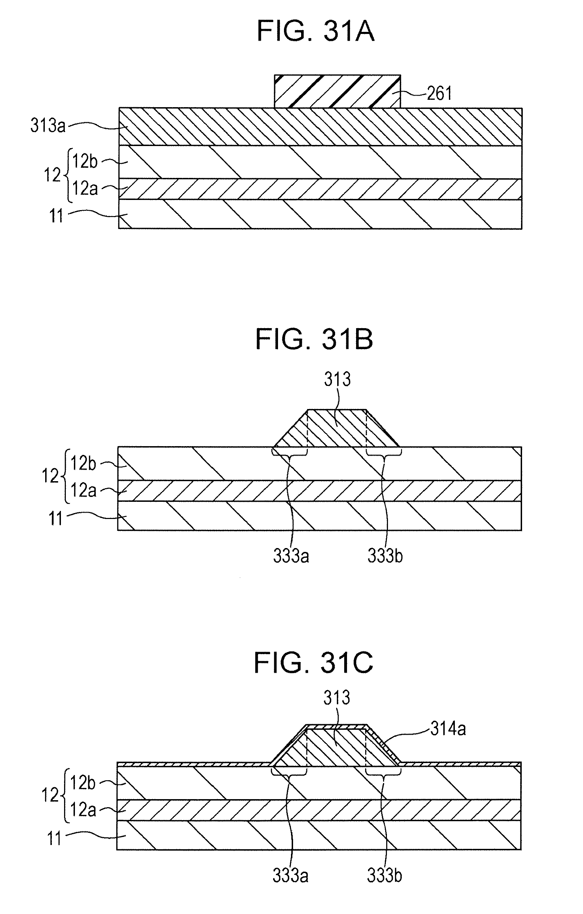

Next, as illustrated in FIG. 31A, a resist pattern 261 is formed on the high-resistivity film 313a in a region where the second buffer layer 313 to be formed. Specifically, photoresist is applied on the high-resistivity film 313a and then exposed and developed by an exposure apparatus to form the resist pattern 261 in the region where the second buffer layer 313 is to be formed. In the embodiment, the second buffer layer 313 is formed in a portion of a region immediately below and between the gate electrode 41 and the drain electrode 43.

Next, as illustrated in FIG. 31B, the high-resistivity film 313a is removed from a region where the resist pattern 261 has not been formed, by dry etching such as RIE or the like. In this case, at least one gas selected from BCl₃, CCl₄, Cl₂, CHF₃, C₂H₆, SF₆, and CF₄ is used as etching gas. By dry etching with such etching gas, the second buffer layer 313 can be formed to have the tapered ends 333a and 333b. Similarly, the second buffer layer 313 can be formed to have the tapered ends 333a and 333b even by adding at least one gas elected from Ar, O₂, H₂, and HBr to the etching gas. As a result, the remaining high-resistivity film 313a forms the second buffer layer 313. Then, the resist pattern 261 is removed with an organic solvent or the like.

Next, as illustrated in FIG. 31C, an AlN film 314a having a thickness of 1 nm to 500 nm, for example, about 30 nm, is formed on the exposed first buffer layer 12 and the second buffer layer 313 by MOVPE. Consequently, the surfaces of the first buffer layer 12 and the second buffer layer 313 are covered with the AlN film 314a.

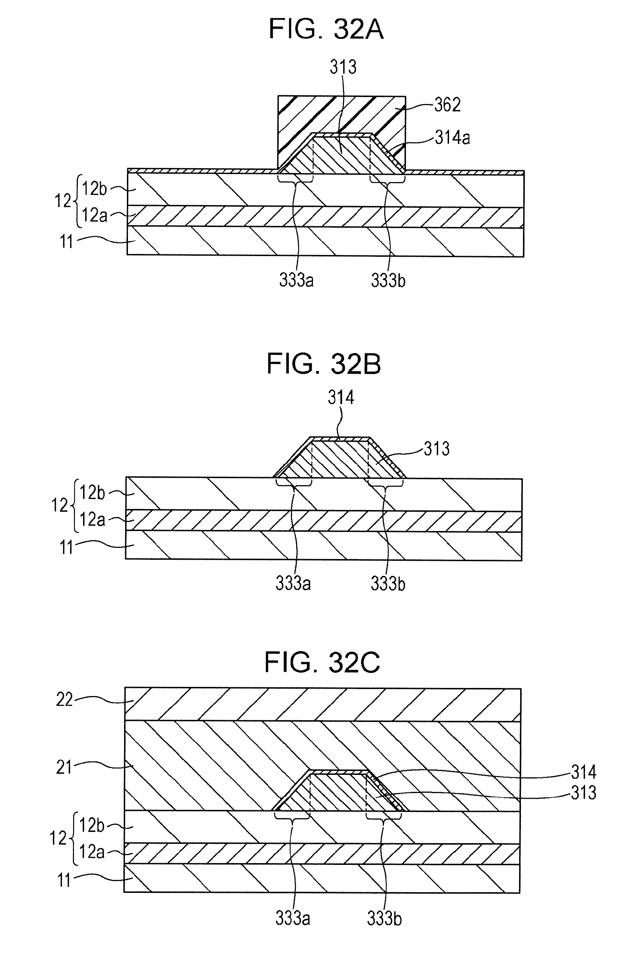

Next, as illustrated in FIG. 32A, a resist pattern 362 is formed on the high-resistivity film 314a in a region where the second buffer layer 313 has been formed. Specifically, photoresist is applied on the high-resistivity film 314a and then exposed and developed by an exposure apparatus to form the resist pattern 362 on the AlN film 314a in the region where the second buffer layer 313 has been formed.

Next, as illustrated in FIG. 32B, the AlN film 314a is removed from a region where the resist pattern 362 has not been formed, by dry etching such as RIE or the like. As a result, the remaining AlN film 314a forms the third buffer layer 314 which covers the second buffer layer 313. Then, the resist pattern 362 is removed with an organic solvent or the like.

Next, as illustrated in FIG. 32C, the electron transit layer 21 composed of i-GaN and the electron supply layer 22 composed of n-AlGaN are sequentially laminated on the exposed first buffer layer 12 and the third buffer layer 314 by MOVPE.

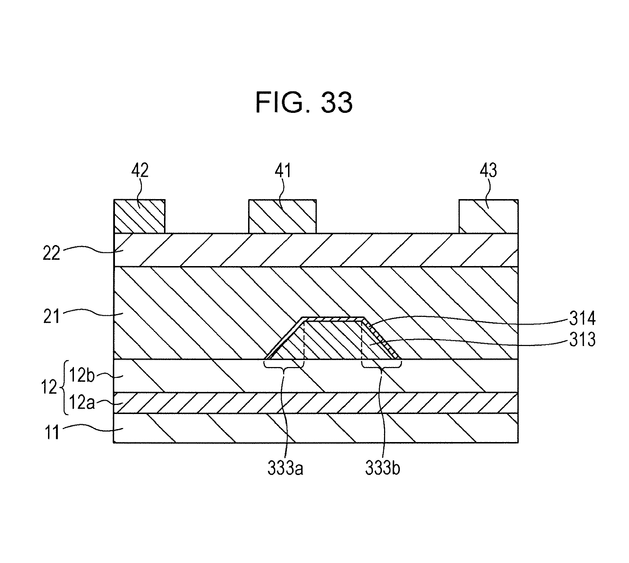

Next, as illustrated in FIG. 33, the gate electrode 41, the source electrode 42, and the drain electrode 43 are formed on the electron supply layer 22.

The semiconductor device according to the embodiment can be manufactured by the manufacturing method described above. The contents other than the above are the same as in the second or fifth embodiment.

### Seventh Embodiment

Next, a seventh embodiment is described. This embodiment relates to a semiconductor device, a power supply unit, and a high-frequency amplifier.

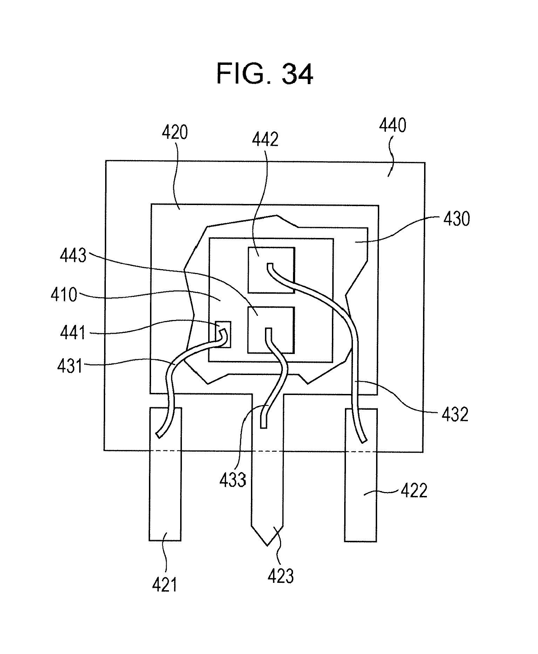

A semiconductor device according to this embodiment is manufactured by discrete-packaging the semiconductor device according to any one of the first to sixth embodiments. The discrete-packaged semiconductor device is described on the basis of FIG. 34. FIG. 34 schematically illustrates the inside of the discrete-packaged semiconductor device, and an electrode arrangement and the like are different from those illustrated in the first to sixth embodiments.

First, the semiconductor device manufactured according to any one of the first to sixth embodiments is cut by dicing or the like, forming a semiconductor chip 410 including HEMT composed of a GaN-based semiconductor material. The semiconductor chip 410 is fixed on a lead frame 420 with a die attaching agent 430 such as a binder. The semiconductor chip 410 corresponds to the semiconductor device according to any one of the first to sixth embodiments.

Next, a gate electrode 441 is connected to a gate lead 421 with a bonding wire 431, a source electrode 442 is connected to a source lead 422 with a bonding wire 432, and a drain electrode 443 is connected to a drain lead 423 with a bonding wire 433. The bonding wires 431, 432, and 433 are composed of a metallic material such as Al or the like. In this embodiment, the gate electrode 441 is a gate electrode pad and is connected to the gate electrode 41 of the semiconductor device according to any one of the first to sixth embodiments. Also, the source electrode 442 is a source electrode pad and is connected to the source electrode 42 of the semiconductor device according to any one of the first to sixth embodiments. Further, the drain electrode 443 is a drain electrode pad and is connected to the drain electrode 43 of the semiconductor device according to any one of the first to sixth embodiments.

Next, resin sealing is performed by a transfer molding method using a molding resin 440. As a result, the discrete-packaged semiconductor device including HEMT using a GaN-based semiconductor material can be manufactured.

Next, a power supply unit and a high-frequency amplifier according to this embodiment are described. The power supply unit and the high-frequency amplifier according to this embodiment each use the semiconductor device according to any one of the first to sixth embodiments.

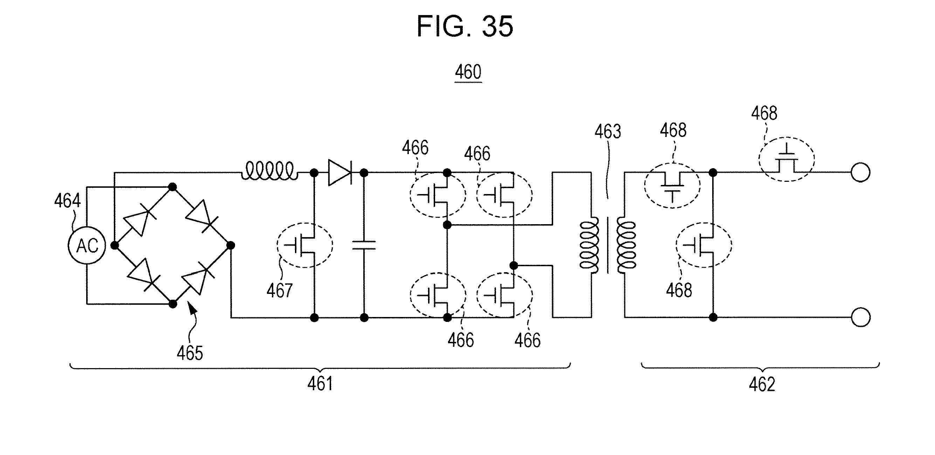

First, the power supply unit according to this embodiment is described on the basis of FIG. 35. The power supply unit 460 according to this embodiment includes a high-voltage primary-side circuit 461, a low-voltage secondary-side circuit 462, and a transformer 463 disposed between the primary-side circuit 461 and the secondary-side circuit 462. The primary-side circuit 461 includes an altering-current power supply 464, a so-called bridge rectifier circuit 465, a plurality of switching elements (in an example illustrated in FIG. 35, four switching elements) 466, and a switching element 467. The secondary-side circuit 462 includes a plurality of switching elements (in an example illustrated in FIG. 35, three switching elements) 468. In an example illustrated in FIG. 35, the semiconductor device according to any one of the first to sixth embodiments can be used as the switching elements 466 and 467 of the primary-side circuit 461. In the secondary-side circuit 462, usual MISFET (metal insulator semiconductor field effect transistor) composed of silicon is used as the switching elements 468.

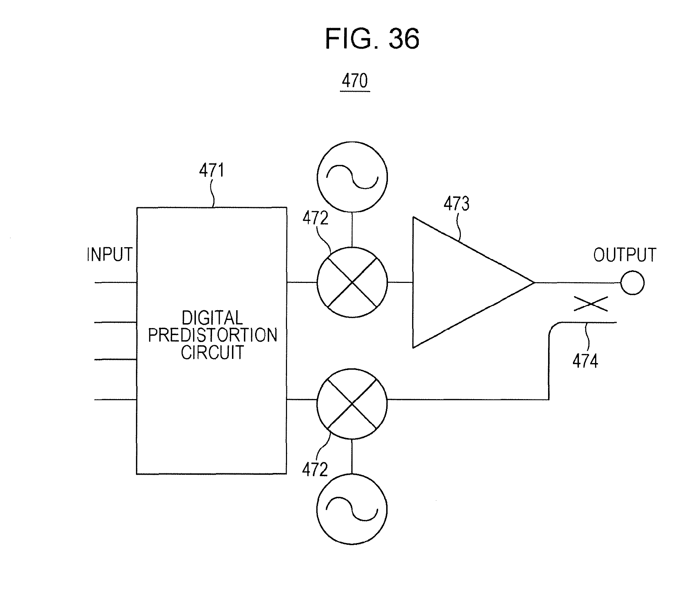

Next, the high-frequency amplifier according to this embodiment is described on the basis of FIG. 36. The high-frequency amplifier 470 according to this embodiment may be applied to, for example, a power amplifier for a base station of cellular phones. The high-frequency amplifier 470 includes a digital predistortion circuit 471, a mixer 472, a power amplifier 473, and a directional coupler 474. The digital predistortion circuit 471 compensates for nonlinear distortion of an input signal. The mixer 472 mixes an input signal compensated for nonlinear distortion with an alternating-current signal. The power amplifier 473 amplifies the input signal mixed with the alternating-current signal. In an example illustrated in FIG. 36, the power amplifier 473 includes the semiconductor device according to any one of the first to sixth embodiments. The directional coupler 473 monitors an input signal and an output signal. In a circuit illustrated in FIG. 36, by using a switch, an output signal can be mixed with an alternating-current signal by the mixer 472 and sent to the digital predistortion circuit 471.

## Claims

1. A semiconductor device comprising:
a first buffer layer formed on a substrate;
a second buffer layer formed on a portion of the first buffer layer;
a third buffer layer formed on the first buffer layer and the second buffer layer;
a first semiconductor layer formed on the third buffer layer;
a second semiconductor layer formed on the first semiconductor layer; and
a gate electrode, a source electrode, and a drain electrode that are formed on the second semiconductor layer,
wherein the second buffer layer is composed of a material with higher resistivity than the first semiconductor layer; and
the second buffer layer is formed in a region immediately below and between the gate electrode and the drain electrode.

2. A semiconductor device comprising:
a first buffer layer formed on a substrate;
a second buffer layer formed on a portion of the first buffer layer;
a third buffer layer formed to cover the second buffer layer;
a first semiconductor layer formed on the first buffer layer and the third buffer layer;
a second semiconductor layer formed on the first semiconductor layer; and
a gate electrode, a source electrode, and a drain electrode that are formed on the second semiconductor layer,
wherein the second buffer layer is composed of a material with higher resistivity than the first semiconductor layer; and
the second buffer layer is formed in a region immediately below and between the gate electrode and the drain electrode.

3. The semiconductor device according to claim 1 or 2,
wherein the second buffer layer is formed in a portion of a region immediately below and between the gate electrode and the drain electrode.

4. The semiconductor device according to any of the preceding claims,
wherein an end of the second buffer layer is partially or entirely formed in a tapered shape.

5. The semiconductor device according to any of claims 1 to 3,
wherein an end of the second buffer layer is partially or entirely formed in a stepped shape.

6. The semiconductor device according to any of the preceding claims,
wherein the second semiconductor layer is not formed in a region immediately below and between the gate electrode and the source electrode.

7. The semiconductor device according to any of the preceding claims,
wherein each of the first semiconductor layer and the second semiconductor layer is composed of a nitride semiconductor.

8. The semiconductor device according to any of the preceding claims,
wherein each of the first buffer layer, the second buffer layer, and the third buffer layer is composed of a material containing a nitride.

9. The semiconductor device according to any of the preceding claims,
wherein the second buffer layer is composed of a GaN-containing material doped with Fe, preferably with a Fe-doping concentration of 1 × 10¹⁷ cm⁻³ or more.

10. The semiconductor device according to any of the preceding claims,
wherein the second buffer layer has a thickness of 30 nm or more and 800 nm or less.

11. The semiconductor device according to any of the preceding claims,
wherein the third buffer layer is composed of a material containing AlN.

12. The semiconductor device according to any of the preceding claims,
wherein the first buffer layer is composed of a material containing AkN or AlGaN.

13. The semiconductor device according to any of the preceding claims,
wherein the first semiconductor layer is composed of a material containing GaN.

14. The semiconductor device according to any of the preceding claims,
wherein the second semiconductor layer is composed of a material containing AlGaN.

15. A power supply unit or an amplifier comprising the semiconductor device according to any of the preceding claims.
